# EUROPEAN PATENT SPECIFICATION

(11) **EP 4 254 470 B1**
(45) Date of publication and mention of the grant of the patent: **05.08.2026**
(21) Application number: 23155260.5
(22) Date of filing: 07.02.2023
(51) Int. Cl.: H10W 99/00, H10W 72/90

(54) **SEMICONDUCTOR PRODUCT AND METHOD FOR MANUFACTURING A SEMICONDUCTOR PRODUCT**
HALBLEITERPRODUKT UND VERFAHREN ZUR HERSTELLUNG EINES HALBLEITERPRODUKTS
PRODUIT SEMI-CONDUCTEUR ET PROCÉDÉ DE FABRICATION D'UN PRODUIT SEMI-CONDUCTEUR

(30) Priority: 24.03.2022 EP 22164115
(43) Date of publication of application: 04.10.2023
(73) Proprietor: Micledi Microdisplays BV, 3000 Leuven (BE); Imec VZW, 3001 Leuven (BE)
(72) Inventor: LE BOULBAR, Emmanuel, 1970 Wezembeek-Oppem (BE); STEUDEL, Soeren, 3020 Herent (BE); VERTOMMEN, Johan, 3220 Holsbeek (BE); MILLER, Robert, 3001 Leuven (BE); DE VOS, Joeri, 3001 Leuven (BE); VAN HUYLENBROECK, Stefaan, 3001 Leuven (BE); BEYNE, Eric, 3001 Leuven (BE); WITTERS, Liesbeth, 3001 Leuven (BE)
(74) Representative: Körfer, Thomas

(56) References cited:
- US-A1- 2021 265 314
- US-A1- 2022 013 502
- US-A1- 2022 077 116

## Description

The invention relates to a semiconductor product, especially comprising at least two wafers being bond together, and a method for manufacturing a semiconductor product.

Generally, in times of an increasing number of complex circuitries, there is a growing need of a semiconductor product and a method for manufacturing a semiconductor product which allows for implementing such circuitries.

US 2022/0013502 A1 discloses a semiconductor package including a first semiconductor chip, a second semiconductor chip, first main connection pad structures, and first dummy connection pad structures. The first main connection pad structures are arranged at an interface between the first semiconductor chip and the second semiconductor chip and arranged to be apart from each other by a first main pitch in a first direction parallel to a top surface of the first semiconductor chip, wherein each of the first main connection pad structures includes a first connection pad electrically connected to the first semiconductor chip, and a second connection pad electrically connected to the second semiconductor chip and contacting the first connection pad. The first dummy connection pad structures are arranged at an interface between the first semiconductor chip and the second semiconductor chip, are arranged to be apart from the first main connection pad structures, and are arranged to be apart from each other by a first dummy pitch in the first direction, the first dummy pitch being greater than the first main pitch.

US 2021/0265314 A1 presents a semiconductor device including a first chip and a second chip bonded to the first chip. The first chip includes: a substrate; a logic circuit disposed on the substrate; and a plurality of first dummy pads that are disposed above the logic circuit, are disposed on a first bonding surface where the first chip is bonded to the second chip, the plurality of first dummy pads not being electrically connected to the logic circuit. The second chip includes a plurality of second dummy pads disposed on the plurality of first dummy pads and a memory cell array provided above the plurality of second dummy pads. A coverage of the first dummy pads on the first bonding surface is different between a first region and a second region, the first region separated from a first end side of the first chip, the second region disposed between the first end side and the first region.

US 2022/0077116 A1 refers to a semiconductor package that includes: a first structure having a first insulating layer disposed on one surface, and first electrode pads and first dummy pads penetrating through the first insulating layer, a second structure having a second insulating layer having the other surface bonded to the one surface and the first insulating layer and disposed on the other surface, and second electrode pads and second dummy pads that penetrate through the second insulating layer, the second electrode pads being bonded to the first electrode pads, respectively, and the second dummy pads being bonded to the first dummy pads, respectively. In the semiconductor chip, ratios of surface areas per unit area of the first and second dummy pads to the first and second insulating layers on the one surface and the other surface gradually decrease toward sides of the first and second structures.

US 2020/0091115 A1 relates to a structure including a first dielectric layer overlying a first substrate. A first connection pad is disposed in a top surface of the first dielectric layer and contacts a first redistribution line. A first dummy pad is disposed in the top surface of the first dielectric layer. The first dummy pad contacts the first redistribution line. A second dielectric layer overlies a second substrate. A second connection pad and a second dummy pad are disposed in the top surface of the second dielectric layer. The second connection pad is bonded to the first connection pad. The first dummy pad is positioned in a manner that it is offset from the second dummy pad so that the first dummy pad and the second dummy pad do not have contact with each other. Disadvantageously, such a configuration does not prevent sharp transitions with respect to the dielectric height profiles of the respective wafers, which exemplarily leads to voids between the wafers, and thus also to a defective bonding.

Accordingly, there is the object to provide a semiconductor product and a method for manufacturing a semiconductor product, wherein the semiconductor product especially comprises at least two wafer being bond together, in order to allow for preventing voids between the at least two wafers, thereby ensuring a high accuracy and efficiency of the respective bonding.

This object is solved by the features of the first independent claim for a semiconductor product and the features of the second independent claim for a method for manufacturing a semiconductor product. The dependent claims contain further developments.

According to a first aspect of the invention, a semiconductor product is provided. Said semiconductor product comprises a first wafer comprising a first active pad array, and at least a second wafer comprising at least a second active pad array. In this context, the first wafer and the at least one second wafer are bonded together. In addition to this, the first wafer and/or the at least one second wafer comprises a transition area being directly adjacent to the first active pad array and/or the at least one second active pad array. Advantageously, voids between the at least two wafers can be avoided, which leads to a highly accurate and efficient bonding.

With respect to the above-mentioned transition area, it is noted that the corresponding transition can be made in a smooth manner. Accordingly, the transition area can also be seen as a transition smoothing area.

According to a first preferred implementation form of the first aspect of the invention, the first wafer and the at least one second wafer are bonded together according to a hybrid bonding technique. Advantageously, for instance, a flexible usage can be guaranteed, which further increases efficiency.

According to the first aspect of the invention, the transition area comprises an inactive pad array. Advantageously, for example, the transition area can be designed in a simple manner, thereby ensuring a particularly high efficiency.

With respect to said inactive pad array, it is noted such an array can also be referred to as dummy pad array in the following. Analogously, the term "inactive" can be referred to as "dummy", and vice versa. It is further noted that said term "inactive" may especially be understood as "electrically inactive".

According to the first aspect of the invention, the first active pad array comprises a first ratio of an electrically conducting material over the corresponding area of the first active pad array.

According to a further preferred implementation form of the first aspect of the invention, the at least one second active pad array comprises at least a second ratio of an electrically conducting material over the corresponding area of the at least one second active pad array. Additionally or alternatively, the electrically conducting material comprises or is copper and/or cobalt and/or tungsten. Advantageously, for instance, the first ratio and the at least one second ratio may be different, thereby preventing voids and defective bonding in an accurate and efficient manner.

With respect to said electrically conducting material, it is noted that the electrically conducting material can especially comprise or be an alloy comprising at least one of copper, cobalt, tungsten, or any combination thereof.

With respect to the first ratio and the at least one second ratio, it is noted that said ratios can especially be at least similar with respect to each other or even the same.

According to the first aspect of the invention, the first ratio of the electrically conducting material is between 2 % and 4 %.

According to a further preferred implementation form of the first aspect of the invention, the first ratio or the at least one second ratio of the electrically conducting material is 3 %. In addition to this or as an alternative, the at least one second ratio of the electrically conducting material is between 1 % and 27 %, preferably between 1 % and 19 %, more preferably between 11 % and 13 %, most preferably 12 %. Advantageously, for example, in this manner, preventing voids and defective bonding can further be optimized.

According to a further preferred implementation form of the first aspect of the invention, the transition area comprises a third ratio of an electrically conducting material, especially comprising or being copper and/or cobalt and/or tungsten, over the corresponding area of the transition area. Advantageously, for instance, the third ratio can easily be adjusted by changing the size and/or the shape of the pads of the inactive pad array.

With respect to said electrically conducting material, it is noted that the electrically conducting material can especially comprise or be an alloy comprising at least one of copper, cobalt, tungsten, or any combination thereof.

According to a further preferred implementation form of the first aspect of the invention, the third ratio of the electrically conducting material does deviate not more than 400 %, preferably not more than 270 %, more preferably not more than 225 %, most preferably not more than 56.25 %, from the at least one second ratio of the electrically conducting material over the corresponding area of the at least one second active pad array. Advantageously, for example, in this manner, preventing voids and defective bonding can further be optimized.

According to a further preferred implementation form of the first aspect of the invention, the third ratio of the electrically conducting material does deviate not more than 400 %, preferably not more than 270 %, more preferably not more than 225 %, most preferably not more than 56.25 %, from the first ratio of the electrically conducting material over the corresponding area of the first active pad array. Advantageously, for instance, with the aid of this configuration, preventing voids and defective bonding can further be improved.

According to a further preferred implementation form of the first aspect of the invention, the first wafer comprises a first further area comprising a first further ratio of an electrically conducting material over the corresponding area of the first further area. In addition to this or as an alternative, the at least one second wafer comprises at least a second further area comprising at least a second further ratio of an electrically conducting material over the corresponding area of the at least one second further area. Further additionally or further alternatively, the electrically conducting material comprises or is copper and/or cobalt and/or tungsten. Advantageously, for example, the respective slope direction can easily be engineered, which allows for enabling the corresponding wafer surfaces to follow each other.

With respect to said electrically conducting material, it is noted that the electrically conducting material can especially comprise or be an alloy comprising at least one of copper, cobalt, tungsten, or any combination thereof.

According to a further preferred implementation form of the first aspect of the invention, the first further area is directly adjacent to the transition area and/or not directly adjacent to the first active pad array. In addition to this or as an alternative the at least one second further area is directly adjacent to the transition area and/or not directly adjacent to the at least one second active pad array. Advantageously, for instance, by enabling the corresponding wafer surfaces to follow each other, voids between the wafers can accurately and efficiently be avoided.

According to a further preferred implementation form of the first aspect of the invention, the first further area comprises a first further inactive pad array. In addition to this or as an alternative, the at least one second further area comprises at least a second further inactive pad array. Advantageously, for example, both the first further area and the at least one second further area can easily, and thus also efficiently, be designed.

According to a further preferred implementation form of the first aspect of the invention, the first further ratio of the electrically conducting material does deviate not more than 56.25 %, preferably not more than 25 %, more preferably not more than 12.5 %, most preferably not more than 1 %, from the at least one second ratio of the electrically conducting material over the corresponding area of the at least one second active pad array. In addition to this or as an alternative, the at least one second further ratio of the electrically conducting material does deviate not more than 56.25 %, preferably not more than 25 %, more preferably not more than 12.5 %, most preferably not more than 1 %, from the first ratio of the electrically conducting material over the corresponding area of the first active pad array. Advantageously, for instance, with the aid of this configuration, preventing voids and defective bonding can further be improved.

According to a further preferred implementation form of the first aspect of the invention, the first further ratio of the electrically conducting material over the corresponding area of the first further area changes according to a first gradient. In addition to this or as an alternative, the at least one second further ratio of the electrically conducting material over the corresponding area of the at least one second further area changes according to a second gradient. Advantageously, for example, both the first gradient and the second gradient can easily be achieved exemplarily by changing the pattern arrangement with respect to the first further inactive pad array or the at least one second further inactive pad array, respectively.

According to a further preferred implementation form of the first aspect of the invention, the third ratio of the electrically conducting material over the corresponding area of the transition area changes according to a third gradient. Advantageously, for instance, the third gradient can easily be achieved exemplarily by changing the corresponding element shape with respect to the inactive pad array. Further advantageously, the gradient can be modified with respect to the respective ratio of the corresponding active array. In this context, for instance, the corresponding element and/or repetitive structure and/or the corresponding shape of the respective pads can be modified.

Before the second aspect of the invention and its preferred implementation forms are explained in the following, it is noted that all the benefits mentioned above regarding the first aspect of the invention and its preferred implementation forms do analogously apply.

According to a second aspect of the invention, a method for manufacturing a semiconductor product is provided. Said method comprises the steps of providing a first wafer comprising a first active pad array, providing at least a second wafer comprising at least a second active pad array, and bonding the first wafer and the at least one second wafer together. In this context, the first wafer and/or the at least one second wafer comprises a transition area being directly adjacent to the first active pad array and/or the at least one second active pad array.

With respect to the above-mentioned transition area, it is noted that the corresponding transition can be made in a smooth manner. Accordingly, the transition area can also be seen as a transition smoothing area.

According to a first preferred implementation form of the second aspect of the invention, the first wafer and the at least one second wafer are bonded together according to a hybrid bonding technique.

According to the second aspect of the invention, the transition area comprises an inactive pad array. In addition to this, the first active pad array comprises a first ratio of an electrically conducting material over the corresponding area of the first active pad array.

According to a further preferred implementation form of the second aspect of the invention, the at least one second active pad array comprises at least a second ratio of an electrically conducting material over the corresponding area of the at least one second active pad array. Additionally or alternatively, the electrically conducting material comprises or is copper and/or cobalt and/or tungsten.

With respect to said electrically conducting material, it is noted that the electrically conducting material can especially comprise or be an alloy comprising at least one of copper, cobalt, tungsten, or any combination thereof.

With respect to the first ratio and the at least one second ratio, it is noted that said ratios can especially be at least similar with respect to each other or even the same.

According to the second aspect of the invention, the first ratio of the electrically conducting material is between 2 % and 4 %.

According to a further preferred implementation form of the second aspect of the invention, the first ratio or the at least one second ratio of the electrically conducting material is 3 %. In addition to this or as an alternative, the at least one second ratio of the electrically conducting material is between 1 % and 27 %, preferably between 1 % and 19 %, more preferably between 11 % and 13 %, most preferably 12 %.

According to a further preferred implementation form of the second aspect of the invention, the transition area comprises a third ratio of an electrically conducting material, especially comprising or being copper and/or cobalt and/or tungsten, over the corresponding area of the transition area.

With respect to said electrically conducting material, it is noted that the electrically conducting material can especially comprise or be an alloy comprising at least one of copper, cobalt, tungsten, or any combination thereof.

According to a further preferred implementation form of the second aspect of the invention, the third ratio of the electrically conducting material does deviate not more than 400 %, preferably not more than 270 %, more preferably not more than 225 %, most preferably not more than 56.25 %, from the at least one second ratio of the electrically conducting material over the corresponding area of the at least one second active pad array.

According to a further preferred implementation form of the second aspect of the invention, the third ratio of the electrically conducting material does deviate not more than 400 %, preferably not more than 270 %, more preferably not more than 225 %, most preferably not more than 56.25 %, from the first ratio of the electrically conducting material over the corresponding area of the first active pad array.

According to a further preferred implementation form of the second aspect of the invention, the first wafer comprises a first further area comprising a first further ratio of an electrically conducting material over the corresponding area of the first further area. In addition to this or as an alternative, the at least one second wafer comprises at least a second further area comprising at least a second further ratio of an electrically conducting material over the corresponding area of the at least one second further area. Further additionally or further alternatively, the electrically conducting material comprises or is copper and/or cobalt and/or tungsten.

With respect to said electrically conducting material, it is noted that the electrically conducting material can especially comprise or be an alloy comprising at least one of copper, cobalt, tungsten, or any combination thereof.

According to a further preferred implementation form of the second aspect of the invention, the first further area is directly adjacent to the transition area and/or not directly adjacent to the first active pad array. In addition to this or as an alternative the at least one second further area is directly adjacent to the transition area and/or not directly adjacent to the at least one second active pad array.

According to a further preferred implementation form of the second aspect of the invention, the first further area comprises a first further inactive pad array. In addition to this or as an alternative, the at least one second further area comprises at least a second further inactive pad array.

According to a further preferred implementation form of the second aspect of the invention, the first further ratio of the electrically conducting material does deviate not more than 56.25 %, preferably not more than 25 %, more preferably not more than 12.5 %, most preferably not more than 1 %, from the at least one second ratio of the electrically conducting material over the corresponding area of the at least one second active pad array. In addition to this or as an alternative, the at least one second further ratio of the electrically conducting material does deviate not more than 56.25 %, preferably not more than 25 %, more preferably not more than 12.5 %, most preferably not more than 1 %, from the first ratio of the electrically conducting material over the corresponding area of the first active pad array.

According to a further preferred implementation form of the second aspect of the invention, the first further ratio of the electrically conducting material over the corresponding area of the first further area changes according to a first gradient. In addition to this or as an alternative, the at least one second further ratio of the electrically conducting material over the corresponding area of the at least one second further area changes according to a second gradient.

According to a further preferred implementation form of the second aspect of the invention, the third ratio of the electrically conducting material over the corresponding area of the transition area changes according to a third gradient.

Exemplary embodiments of the invention are now further explained with respect to the drawings by way of example only, and not for limitation. In the drawings:
- Fig. 1: shows exemplary surface acoustic wave images which highlight images obtained for (left) wafer bonded with array on top and bottom, (center) top wafer bonded to blanket carrier wafer, and (right) bottom wafer bonded to blanket carrier;
- Fig. 2: shows a first exemplary embodiment of an inventive semiconductor product;
- Fig. 3: shows a second exemplary embodiment of an inventive semiconductor product;
- Fig. 4: shows an exemplary embodiment of an inventive transition smoothing based on a gradient profile; and
- Fig. 5: shows a flow chart of an example of a method for manufacturing a semiconductor product.

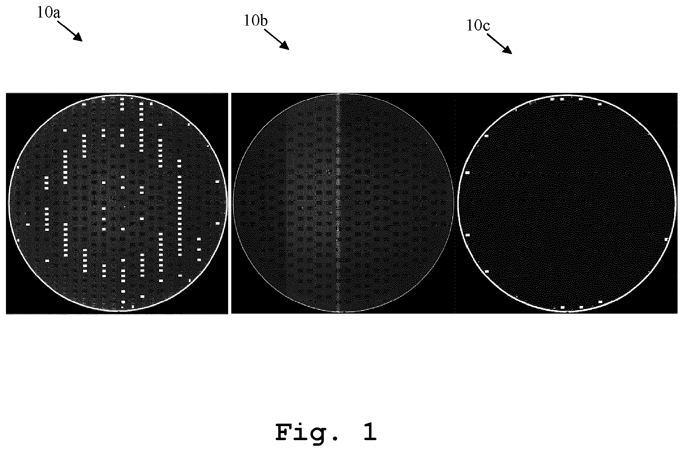

Firstly, with special respect to Fig. 1, some introductory explanations should be given in the following. Generally, in the context of bonding techniques, especially hybrid bonding technique, two wafers, exemplarily a top wafer or a first wafer, respectively, and a bottom wafer or a second wafer, respectively, are bonded together.

Typically, the surfaces of the two wafers each have a number of copper (Cu) structures (pads) surrounded by Oxides (Ox). By bonding the two wafers together the Cu pads on both wafers bond together (making an electrical contact) and the surrounding dielectrics also bond together.

Furthermore, the Cu pads are typically arranged in very large arrays of Cu pads, surrounded by equally large areas of pure dielectric. In a successful hybrid bonding process, all the Cu pad to pad bonds make a good electrical contact and all the dielectric also make a good contact. Parameters that have a very big impact on the quality of the hybrid bonding are typically related to the global and the local planarity of both wafers. Typically, most critical failure mechanism are the creation of small or large voids between both wafers that prevent the Cu-Cu bond and dielectric bond, exemplarily Oxid-Oxid bond, from forming.

With respect to said dielectric or dielectric bond, respectively, it is noted that the dielectric can especially comprise or be silicon nitride and/or silicon carbonitride.

Fig. 1 shows Scanning Acoustic Microscopy (SAM) images taken after top and bottom wafer were bonded and annealed. Left image (reference sign 10a) shows the results obtained when top and bottom wafer both have the pad array, with a low to high copper to dielectric percentage transition lying on top of each other. The white square area seen on the SAM image are indicating voids, which are present at the bonding interface. A yield of about 60% is reached using the conventional design.

Moreover, centre (reference sign 10b) and right (reference sign 10c) images correspond to top and bottom wafer being bond to wafer with dielectric layers that do not have any copper pad patterning. The results of these experiments show that the interaction between the pads region lead to voids.

The hybrid bonding technique consists of bonding dielectric and dielectric/copper array region from two wafers, the copper/dielectric region being organized into an array. The area where copper/dielectric element array is present, called pad array, could not yield to 100% successful bonding in the area where pads are present.

Large voids, air gap at the interface between the two bonded wafer, prevented the process to continue further. According to said Fig. 1, a white area in the surface acoustic waves images reveals the voids area obtained for large array, while bonding array on top of each other or on blanket wafers.

Typically, bonding wafers where pad transition occur at the same location results in a higher chance of unsuccessful bonding. Furthermore, similar bonding of these individuals wafers to a blanket carrier resulted in successful bonding.

It is further noted that the Cu pad arrays may especially be made through a single damascene process. The planarity of the surface may then be largely determined by a final chemical mechanical polishing (CMP) process. In this context, it should be made sure that the transition from the arrays with the Cu pads to the large dielectric fields, exemplarily oxide fields, or from arrays with different Cu pads density, is planar, for instance, one area is not recessed relative to the other.

Typically, a step in height, also called roll-off or slope in the following, often appears at the pad/dielectric array to dielectric transition (or low density to high density Cu pads transition). This step/slope is induced by a couple of factors. Vias are etched to connect top layer to underneath layers. Typically, said vias, which have different size and depth, are filled with a barrier layer, copper seed and copper electroplated.

The introduction of a pattern likely introduce a slight change in copper thickness homogeneity between the array area which have a low filling factor with smallest pad size (or no patterned array) compared to the area with a higher filling factor with bigger pad size. When the copper/barrier are mechanically/chemically polished away, the slight difference introduce by the patterns variation especially induce the copper/barrier to be removed first in the region where the highest filling factor is present.

The transition is especially produced due to lower dielectric to barrier selectivity. Once the barrier is completely removed, the dielectric is being CMP'd away slightly faster than the barrier.

These factors especially introduce a step in height with a certain slope at the interface between this patterned/non-patterned area (high/low transition area). The steeper the slope, the lower the chance of successful bonding.

Furthermore, the cumulative step in height or slope, which is created at the array to dielectric transition (or low to high density transition), is especially responsible for the void and reduce process yield.

Because the slope from both top and bottom wafer usually land on top of each other, the cumulative effect leads the complete array to void. The cumulative effect is especially responsible for lower yield, a less robust process. Accordingly, it is particularly important to enable successful, robust process integration for bonding, especially hybrid bonding.

In addition to this, it is noted that whereas perfect flatness cannot be achieved, the cumulative effect to a step on both the bottom and the top wafer should be avoided. Furthermore, although the active arrays typically coincide, it should be made sure that the edges of the arrays do not coincide exemplarily by introducing dummy pads around the arrays on one of the wafers of the respective pair.

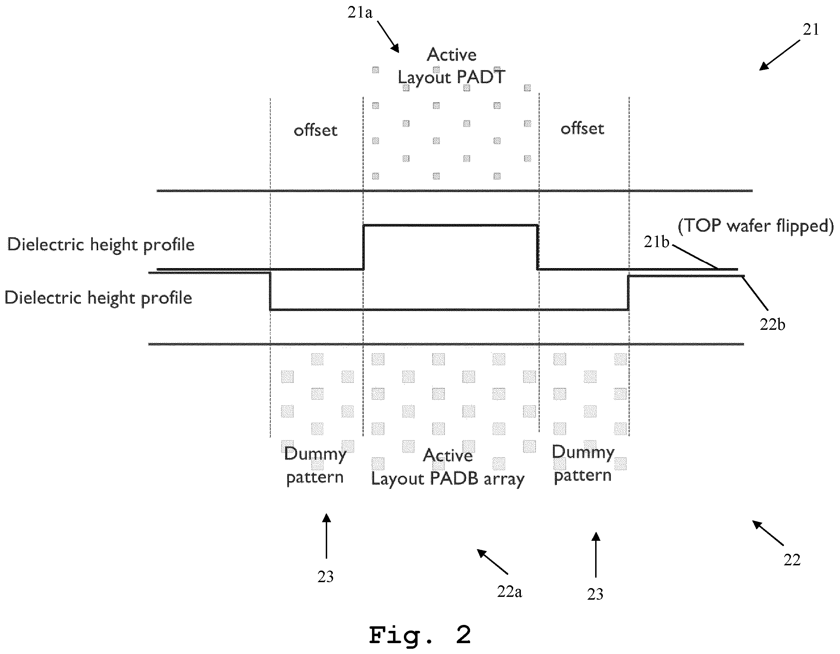

Now, with respect to Fig. 2, an exemplary embodiment of an inventive semiconductor product is illustrated and described. Said semiconductor product comprises a first wafer 21 comprising a first active pad array 21a, and a second wafer 22 comprising a second active pad array 22a, wherein the first wafer 21 and the second wafer 22 are bonded together especially according to a hybrid bonding technique.

In this context, the first wafer 21 can also be seen as a top wafer, whereas the second wafer 22 can also be seen as a bottom wafer. In addition to this, bottom wafer 22 comprises a transition area 23 being directly adjacent to the second active pad array 22a. As it can further be seen from Fig. 2, said transition area 23 comprises an inactive pad array, exemplarily a dummy pattern or dummy pad array.

Furthermore, the first active pad array 21a comprises a first ratio of an electrically conducting material over the corresponding area of the first active pad array, whereas the second active pad array 22a comprises a second ratio of an electrically conducting material over the corresponding area of the at least one second active pad array.

Exemplarily, it is noted that the electrically conducting material is copper. Further exemplarily, the first ratio of the electrically conducting material is 3 %, whereas the second ratio of the electrically conducting material is 12 %. Moreover, the transition area comprises a third ratio of an electrically conducting material, exemplarily being copper, over the corresponding area of the transition area. Exemplarily, said third ratio is 12 %.

For the sake of completeness, it is noted that Fig. 2 additionally illustrates the dielectric height profile 21b regarding the substrate of the first wafer 21, and the dielectric height profile 22b regarding the substrate of the second wafer 22.

Furthermore, the embodiment according to Fig. 2 can be summarized in other words and additionally be complemented as follows:
On one of the two wafers (for instance, the bottom wafer), a dummy pattern of pads is introduced to offset the low to high transition area further away from the low to high transition area that occur on the other paired wafer (for instance, the top wafer).

The steep transition that occurs at the array to dielectric or high to low transition, is now moved away from each other by some distance, enable successful hybrid bonding. The local slope on one wafer is now seeing a flat local surface on the other wafer, the cumulative slope effect no longer plays a detrimental role in the bonding mechanism.

Note that the step in height showed in Fig. 2 may be very local and very small (few nm). The flatness of the surface on which it bonds may have a roughness below 1 nm over a few micron. The long range bonding surface may be considered flat outside of these slope events.

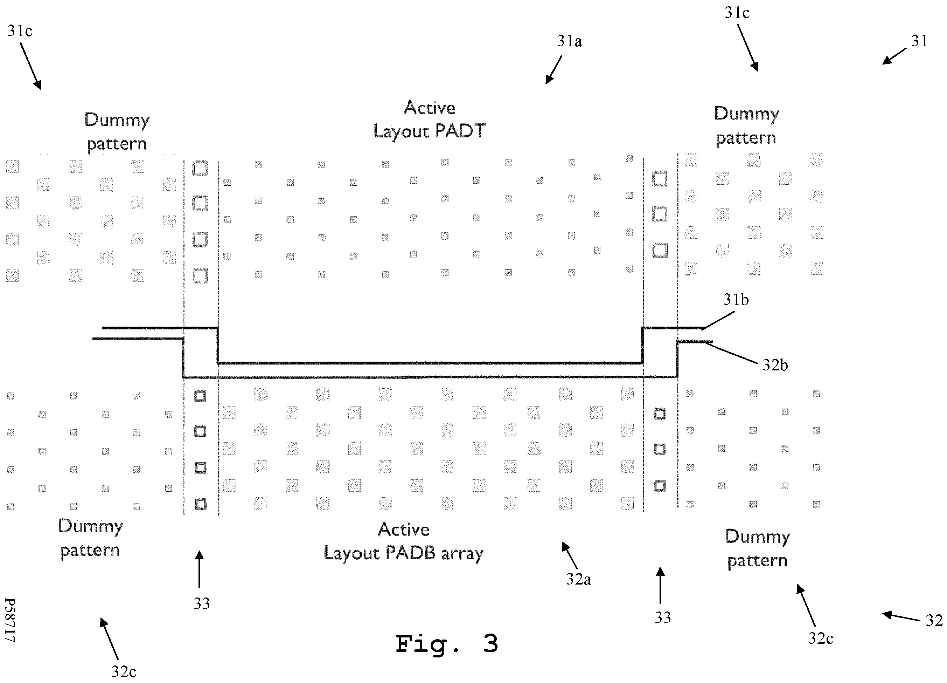

Before Fig. 3 is explained in greater detail in the following, the definition of the filling factor should be mentioned: Ratio of electrically conducting material, exemplarily copper, in an area defined by the repeating unit cell, and/or ratio of copper area over a defined area.

In this context, an area which contains the highest area of copper is defined as the area with a high filling factor, whereas an area with lowest area of copper is defined as the area with a low filling factor. A gradual change of copper surface area (for instance, reducing or increase pad size and/or removing/adding pads) over a defined distance would lead to a smooth change of filling factor, which we call gradient.

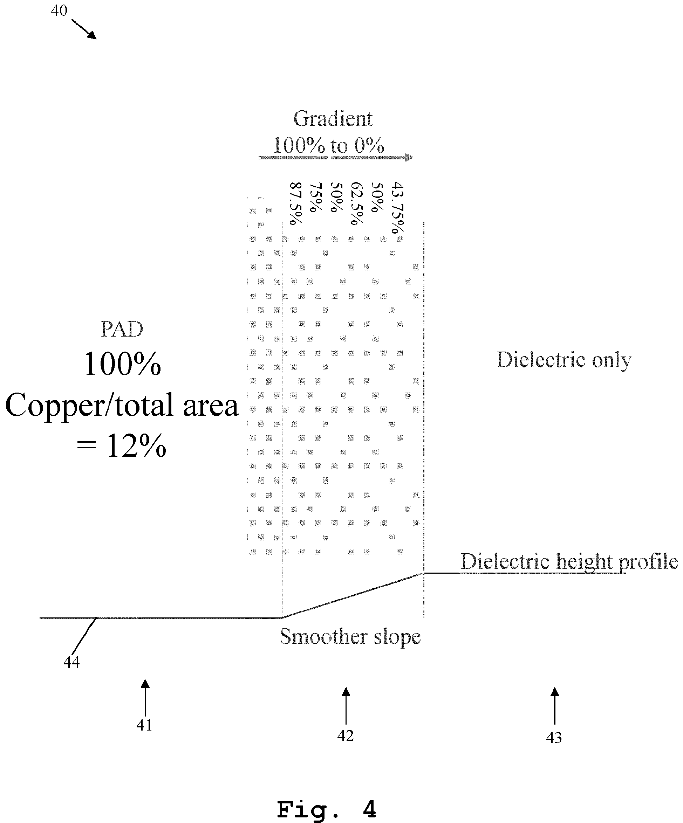

In advance, with respect to said gradient, it is noted that a corresponding exemplary embodiment will be explained below in the context of Fig. 4. Now, with respect to Fig. 3, a second exemplary embodiment of the inventive semiconductor product is shown.

Said semiconductor product comprises a first wafer 31 comprising a first active pad array 31a, and a second wafer 32 comprising at least a second active pad array 32a. In this context, the first wafer 31 and the second wafer 32 are bonded together especially according to a hybrid bonding technique.

In addition to this, each of the first wafer 31, exemplarily the top wafer, and the second wafer 32, exemplarily the bottom wafer, comprises a transition area 33 being directly adjacent to the first active pad array 31a or the second active pad array 32a, respectively. Furthermore, the transition area 33 comprises an inactive pad array as it can also be seen from Fig. 3.

Moreover, the first active pad array 31a comprises a first ratio of an electrically conducting material, exemplarily copper, over the corresponding area of the first active pad array 31a, whereas the second active pad array 32a comprises a second ratio of an electrically conducting material, exemplarily copper, over the corresponding area of the second active pad array 32a.

In this context, the first ratio of the electrically conducting material is 3 %, whereas the second ratio of the electrically conducting material is 12 %. Furthermore, the transition area 33 comprises a third ratio of an electrically conducting material, exemplarily being copper, over the corresponding area of the transition area 33. For instance, said third ratio is 12 %.

As it can further be seen from Fig. 3, the first wafer 31 comprises a first further area 31c comprising a first further ratio of an electrically conducting material, exemplarily copper, over the corresponding area of the first further area 31c, whereas the second wafer 32 comprises a second further area 32c comprising a second further ratio of an electrically conducting material, exemplarily copper, over the corresponding area of the second further area 32c. Exemplarily, the first further ratio is 12 %, whereas the second further ratio is 3 %.

It is further noted that the first further area 31c is directly adjacent to the transition area 33 and not directly adjacent to the first active pad array 31a, whereas the second further area 32c is directly adjacent to the transition area 33 and not directly adjacent to the second active pad array 32a. Moreover, the first further area 31c comprises a first further inactive pad array, exemplarily a dummy pattern or dummy pad array, whereas the second further area 32c comprises a second further inactive pad array, exemplarily a dummy pattern or dummy pad array.

For the sake of completeness, it is noted that Fig. 3 additionally illustrates the dielectric height profile 31b regarding the substrate of the first wafer 31, and the dielectric height profile 32b regarding the substrate of the second wafer 32.

Furthermore, the embodiment according to Fig. 3 can be summarized in other words and additionally be complemented as follows:
The layout design can be varied to reverse the profile especially in order to modify the slope orientation. On one wafer the arrays with pads is sticking out, whereas on the other wafer the arrays with pads are recessed (see Fig 3).

A change of filling factor percentage can help to engineer the slope direction and enable wafer surface to follow each other rather than separating wafer from each other. When wafer pairs are being bonded, the transition slopes are now slotting within each other.

This engineering brings the arrays closer to each other, facilitating the bonding and resulting in a higher chance of successful bonding, especially hybrid bonding. The cumulative effect which is especially responsible for voids can advantageously be cancelled. A small offset, especially in the form of the transition area 33, may be required to take into account potential misalignment.

Now, with respect to Fig. 4, illustrating an exemplary embodiment of an inventive transition smoothing based on a gradient profile, it is noted that a gradient change of filling factor can also be introduced to reduce step in height, slope sharpness.

This can be introduced by changing the pattern pitch, the pattern arrangement or change the size of the pad (bigger or smaller critical dimension, CD), depending on what is being looked after. Note the change of CD will introduce process change which may have an impact on the overall integration. This solution might be particularly interesting when the filling factor is very high in the array and that regions on the rest of the wafer are dielectric.

A smooth, controlled transition will especially be required to enable successful bonding to occur everywhere on the wafer, not just in the array. Advantageously, a filling factor change could be achieved in the following ways: Change of pattern arrangement and/or change of element shape such as bigger CD, rectangular shape, cross-like shape, round shape, diamond shape. Further advantageously, it is noted that all shapes could potentially be used for reducing/increasing the filling factor. As a further advantage, said shape or shapes, respectively, or another shape in this context can especially be based on at least one of a lines type structure, a zig-zag type structure, a meanders type structure, or any combination thereof.

Exemplarily, in Fig. 4 a part of a wafer 40 is shown, wherein the corresponding dielectric height profile 44 is also depicted. In this context, a first area 41 comprises an active pad array with for example 12 % filling factor or ratio of copper over the corresponding area of said active pad array, respectively.

In addition to this, a second area 42 is directly adjacent to said first area 41 and to a third area 43, wherein said third area 43 comprises only dielectric material and is not directly adjacent to the first area 41. As it can be seen regarding the second area 42, the corresponding ratio of copper over the second area 42 changes according to a gradient.

Exemplarily, the corresponding gradient profile of the second area 42 is 87.5 % - 75 % - 50 % - 62.5 % - (62.5 %) - 50 % - 43.75 % especially with respect to the filling factor of the first area 41 corresponding to 100 %. Accordingly, in this exemplary case, the filling factor profile of the second area 42 is as follows: 10.5 % - 9 % - 6 % - 7.5 % - (7.5 %) - 6 % - 5.25 %.

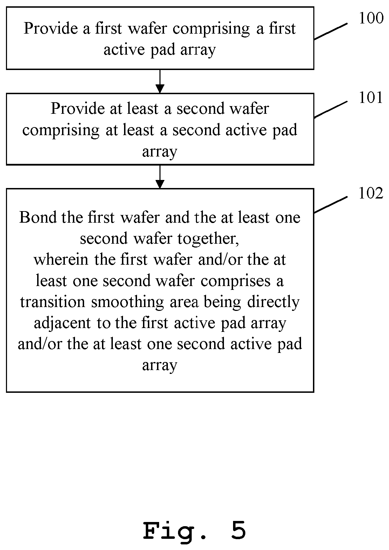

Finally, Fig. 5 shows a flow chart of an example of a method for manufacturing a semiconductor product. In a first step 100, a first wafer comprising a first active pad array is provided. Then, in a second step 101, at least a second wafer comprising at least a second active pad array is provided. Furthermore, in a third step 102, the first wafer and the at least one second wafer are bonded together. In this context, the first wafer and/or the at least one second wafer comprises a transition area being directly adjacent to the first active pad array and/or the at least one second active pad array.

## Claims

1. A semiconductor product comprising:
a first wafer (21, 31) comprising a first active pad array (21a, 31a), and
at least a second wafer (22, 32) comprising at least a second active pad array (22a, 32a),
wherein the first wafer (21, 31) and the at least one second wafer (22, 32) are bonded together,
wherein the first wafer (21, 31) and/or the at least one second wafer (22, 32) comprises a transition area (23, 33) being directly adjacent to the first active pad array (21a, 31a) and/or the at least one second active pad array (22a, 32a), and
wherein the transition area (23, 33) comprises an inactive pad array,
**characterized in that**
the first active pad array (21a, 31a) comprises a first ratio of an electrically conducting material over the corresponding area of the first active pad array (21a, 31a), and
the first ratio of the electrically conducting material is between 2 % and 4 %.

2. The semiconductor product according to claim 1,
wherein the first wafer (21, 31) and the at least one second wafer (22, 32) are bonded together according to a hybrid bonding technique.

3. The semiconductor product according to claim 1 or 2,
wherein the at least one second active pad array (22a, 32a) comprises at least a second ratio of an electrically conducting material over the corresponding area of the at least one second active pad array (22a, 32a), and/or
wherein the electrically conducting material comprises or is copper and/or cobalt and/or tungsten.

4. The semiconductor product according to claim 1 or 3,
wherein the first ratio or the at least one second ratio of the electrically conducting material is 3 %, and/or
wherein the at least one second ratio of the electrically conducting material is between 1 % and 27 %, preferably between 1 % and 19 %, more preferably between 11 % and 13 %, most preferably 12 %.

5. The semiconductor product according to any of the claims 1 to 4,
wherein the transition area (23, 33) comprises a third ratio of an electrically conducting material, especially comprising or being copper and/or cobalt and/or tungsten, over the corresponding area of the transition area (23, 33).

6. The semiconductor product according to claim 5,
wherein the third ratio of the electrically conducting material does deviate not more than 400 %, preferably not more than 270 %, more preferably not more than 225 %, most preferably not more than 56.25 %, from the at least one second ratio of the electrically conducting material over the corresponding area of the at least one second active pad array (22a, 32a).

7. The semiconductor product according to claim 5,
wherein the third ratio of the electrically conducting material does deviate not more than 400 %, preferably not more than 270 %, more preferably not more than 225 %, most preferably not more than 56.25 %, from the first ratio of the electrically conducting material over the corresponding area of the first active pad array (21a, 31a).

8. The semiconductor product according to any of the claims 1 to 7,
wherein the first wafer (21, 31) comprises a first further area (31c) comprising a first further ratio of an electrically conducting material over the corresponding area of the first further area (31c),
wherein the first further area (31c) is directly adjacent to the transition area (23, 33) and/or not directly adjacent to the first active pad array (21a, 31a), and/or
wherein the at least one second wafer (22, 32) comprises at least a second further area (32c) comprising at least a second further ratio of an electrically conducting material over the corresponding area of the at least one second further area (32c),
wherein the at least one second further area (32c) is directly adjacent to the transition area (23, 33) and/or not directly adjacent to the at least one second active pad array (22a, 32a), and/or
wherein the electrically conducting material comprises or is copper and/or cobalt and/or tungsten.

9. The semiconductor product according to claim 8,
wherein the first further area (31c) comprises a first further inactive pad array, and/or
wherein the at least one second further area (32c) comprises at least a second further inactive pad array.

10. The semiconductor product according to claim 8 or 9,
wherein the first further ratio of the electrically conducting material does deviate not more than 56.25 %, preferably not more than 25 %, more preferably not more than 12.5 %, most preferably not more than 1 %, from the at least one second ratio of the electrically conducting material over the corresponding area of the at least one second active pad array (22a, 32a), and/or
wherein the at least one second further ratio of the electrically conducting material does deviate not more than 56.25 %, preferably not more than 25 %, more preferably not more than 12.5 %, most preferably not more than 1 %, from the first ratio of the electrically conducting material over the corresponding area of the first active pad array (21a, 31a).

11. The semiconductor product according to any of the claims 8 to 10,
wherein the first further ratio of the electrically conducting material over the corresponding area of the first further area (31c) changes according to a first gradient, and/or
wherein the at least one second further ratio of the electrically conducting material over the corresponding area of the at least one second further area (32c) changes according to a second gradient.

12. The semiconductor product according to any of the claims 5 to 7,
wherein the third ratio of the electrically conducting material over the corresponding area of the transition area (23, 33) changes according to a third gradient.

13. A method for manufacturing a semiconductor product, the method comprising the steps of:
providing a first wafer (21, 31) comprising a first active pad array (21a, 31a),
providing at least a second wafer (22, 32) comprising at least a second active pad array (22a, 32a), and
bonding the first wafer (21, 31) and the at least one second wafer (22, 32) together,
wherein the first wafer (21, 31) and/or the at least one second wafer (22, 32) comprises a transition area (23, 33) being directly adjacent to the first active pad array (21a, 31a) and/or the at least one second active pad array (22a, 32a),
wherein the transition area (23, 33) comprises an inactive pad array,
**characterized in that**
the first active pad array (21a, 31a) comprises a first ratio of an electrically conducting material over the corresponding area of the first active pad array (21a, 31a), and
the first ratio of the electrically conducting material is between 2 % and 4 %.

## Patentansprüche

1. Halbleiterprodukt, aufweisend:
einen ersten Wafer (21, 31) mit einem ersten aktiven Pad-Array (21a, 31a), und
mindestens einen zweiten Wafer (22, 32) mit mindestens einem zweiten aktiven Pad-Array (22a, 32a),
wobei der erste Wafer (21, 31) und der mindestens eine zweite Wafer (22, 32) miteinander verbunden sind,
wobei der erste Wafer (21, 31) und/oder der mindestens eine zweite Wafer (22, 32) einen Übergangsbereich (23, 33) aufweist, der unmittelbar an das erste aktive Pad-Array (21a, 31a) und/oder das mindestens eine zweite aktive Pad-Array (22a, 32a) angrenzt, und
wobei der Übergangsbereich (23, 33) ein inaktives Pad-Array aufweist,
**dadurch gekennzeichnet, dass**
das erste aktive Pad-Array (21a, 31a) einen ersten Anteil eines elektrisch leitenden Materials über den entsprechenden Bereich der ersten aktiven Pad-Array (21a, 31a) aufweist, und
der erste Anteil des elektrisch leitenden Materials zwischen 2 % und 4 % beträgt.

2. Halbleiterprodukt nach Anspruch 1,
wobei der erste Wafer (21, 31) und der mindestens eine zweite Wafer (22, 32) gemäß einer Hybridbonding-Technik miteinander verbunden werden.

3. Halbleiterprodukt nach Anspruch 1 oder 2,
wobei das mindestens eine zweite aktive Pad-Array (22a, 32a) mindestens einen zweiten Anteil eines elektrisch leitenden Materials über den entsprechenden Bereich des mindestens einen zweiten aktiven Pad-Array (22a, 32a) aufweist, und/oder
wobei das elektrisch leitende Material Kupfer und/oder Kobalt und/oder Wolfram enthält oder daraus besteht.

4. Halbleiterprodukt nach Anspruch 1 oder 3,
wobei der erste Anteil oder der mindestens eine zweite Anteil des elektrisch leitenden Materials 3 % beträgt, und/oder
wobei der mindestens eine zweite Anteil des elektrisch leitenden Materials zwischen 1 % und 27 %, vorzugsweise zwischen 1 % und 19 %, weiter bevorzugt zwischen 11 % und 13 %, höchst bevorzugt 12 %, beträgt.

5. Halbleiterprodukt nach einem der Ansprüche 1 bis 4,
wobei der Übergangsbereich (23, 33) einen dritten Anteil eines elektrisch leitenden Materials, das insbesondere Kupfer und/oder Kobalt und/oder Wolfram enthält oder daraus besteht, über den entsprechenden Bereich des Übergangsbereichs (23, 33) aufweist.

6. Halbleiterprodukt nach Anspruch 5,
wobei der dritte Anteil des elektrisch leitenden Materials um nicht mehr als 400 %, vorzugsweise um nicht mehr als 270 %, weiter bevorzugt um nicht mehr als 225 %, höchst bevorzugt um nicht mehr als 56,25 %, von dem mindestens einen zweiten Anteil des elektrisch leitenden Materials über den entsprechenden Bereich des mindestens einen zweiten aktiven Pad-Array (22a, 32a) abweicht.

7. Halbleiterprodukt nach Anspruch 5,
wobei der dritte Anteil des elektrisch leitenden Materials um nicht mehr als 400 %, vorzugsweise um nicht mehr als 270 %, weiter bevorzugt um nicht mehr als 225 %, höchst bevorzugt um nicht mehr als 56,25 %, von dem ersten Anteil des elektrisch leitenden Materials über den entsprechenden Bereich des ersten aktiven Pad-Array (21a, 31a) abweicht.

8. Halbleiterprodukt nach einem der Ansprüche 1 bis 7,
wobei der erste Wafer (21, 31) einen ersten weiteren Bereich (31c) mit einem ersten weiteren Anteil eines elektrisch leitenden Materials über den entsprechenden Bereich des ersten weiteren Bereichs (31c) aufweist,
wobei der erste weitere Bereich (31c) unmittelbar an den Übergangsbereich (23, 33) angrenzt, und/oder nicht unmittelbar an das erste aktive Pad-Array (21a, 31a) angrenzt, und/oder
wobei der mindestens eine zweite Wafer (22, 32) mindestens einen zweiten weiteren Bereich (32c) mit mindestens einem zweiten weiteren Anteil eines elektrisch leitenden Materials über den entsprechenden Bereich des mindestens einen zweiten weiteren Bereichs (32c) aufweist,
wobei der mindestens eine zweite weitere Bereich (32c) unmittelbar an den Übergangsbereich (23, 33) angrenzt und/oder nicht unmittelbar an das mindestens eine zweite aktive Pad-Array (22a, 32a) angrenzt, und/oder
wobei das elektrisch leitende Material Kupfer und/oder Kobalt und/oder Wolfram enthält oder daraus besteht.

9. Halbleiterprodukt nach Anspruch 8,
wobei der erste weitere Bereich (31c) ein erstes weiteres inaktives Pad-Array aufweist, und/oder
wobei der mindestens eine zweite weitere Bereich (32c) mindestens ein zweites weiteres inaktives Pad-Array aufweist,

10. Halbleiterprodukt nach Anspruch 8 oder 9,
wobei der erste weitere Anteil des elektrisch leitenden Materials um nicht mehr als 56,25 %, vorzugsweise um nicht mehr als 25 %, weiter bevorzugt um nicht mehr als 12,5 %, höchst bevorzugt um nicht mehr als 1 %, von dem mindestens einen zweiten Anteil des elektrisch leitenden Materials über den entsprechenden Bereich des mindestens einen zweiten aktiven Pad-Array (22a, 32a) abweicht, und/oder
wobei der mindestens eine zweite weitere Anteil des elektrisch leitenden Materials um nicht mehr als 56,25 %, vorzugsweise um nicht mehr als 25 %, weiter bevorzugt um nicht mehr als 12,5 %, höchst bevorzugt um nicht mehr als 1 %, von dem ersten Anteil des elektrisch leitenden Materials über den entsprechenden Bereich der ersten aktiven Pad-Array (21a, 31a) abweicht.

11. Halbleiterprodukt nach einem der Ansprüche 8 bis 10,
wobei sich der erste weitere Anteil des elektrisch leitenden Materials über den entsprechenden Bereich des ersten weiteren Bereichs (31c) gemäß einem ersten Gradienten ändert, und/oder
wobei sich der mindestens eine zweite weitere Anteil des elektrisch leitenden Materials über den entsprechenden Bereich des mindestens einen zweiten weiteren Bereichs (32c) gemäß einem zweiten Gradienten ändert.

12. Halbleiterprodukt nach einem der Ansprüche 5 bis 7,
wobei sich der dritte Anteil des elektrisch leitenden Materials über den entsprechenden Bereich des Übergangsbereichs (23, 33) gemäß einem dritten Gradienten ändert.

13. Verfahren zur Herstellung eines Halbleiterprodukts, wobei das Verfahren die folgenden Schritte aufweist:
Bereitstellen eines ersten Wafers (21, 31) mit einem ersten aktiven Pad-Array (21a, 31a),
Bereitstellen mindestens eines zweiten Wafers (22, 32) mit mindestens einem zweiten aktiven Pad-Array (22a, 32a), und
Verbinden des ersten Wafers (21, 31) und des mindestens einen zweiten Wafers (22, 32) miteinander,
wobei der erste Wafer (21, 31) und/oder der mindestens eine zweite Wafer (22, 32) einen Übergangsbereich (23, 33) aufweist, der unmittelbar an das erste aktive Pad-Array (21a, 31a) und/oder das mindestens eine zweite aktive Pad-Array (22a, 32a) angrenzt,
wobei der Übergangsbereich (23, 33) ein inaktives Pad-Array aufweist,
**dadurch gekennzeichnet, dass**
das erste aktive Pad-Array (21a, 31a) einen ersten Anteil eines elektrisch leitenden Materials über den entsprechenden Bereich der ersten aktiven Pad-Array (21a, 31a) aufweist, und
der erste Anteil des elektrisch leitenden Materials zwischen 2 % und 4 % beträgt.

## Revendications

1. Produit semi-conducteur comportant :
une première plaquette (21, 31) comportant une première matrice de pastilles active (21a, 31a), et
au moins une seconde plaquette (22, 32) comportant au moins une seconde matrice de pastilles active (22a, 32a),
dans lequel la première plaquette (21, 31) et la au moins une seconde plaquette (22, 32) sont assemblées ensemble,
dans lequel la première plaquette (21, 31) et/ou la au moins une seconde plaquette (22, 32) comporte une zone de transition (23, 33) qui est directement adjacente à la première matrice de pastilles active (21a, 31a) et/ou la au moins une seconde matrice de pastilles active (22a, 32a), et
dans lequel la zone de transition (23, 33) comporte une matrice de pastilles inactive,
**caractérisé en ce que**
la première matrice de pastilles active (21a, 31a) présente un premier taux d'un matériau électriquement conducteur sur la zone correspondante de la première matrice de pastilles active (21a, 31a), et
le premier taux du matériau électriquement conducteur est compris entre 2 % et 4 %.

2. Produit semi-conducteur selon la revendication 1,
dans lequel la première plaquette (21, 31) et la au moins une seconde plaquette (22, 32) sont assemblées ensemble selon une technique d'assemblage hybride.

3. Produit semi-conducteur selon la revendication 1 ou 2,
dans lequel le au moins une seconde matrice de pastilles active (22a, 32a) comporte au moins un deuxième taux d'un matériau électriquement conducteur sur la zone correspondante du au moins une seconde matrice de pastilles active (22a, 32a), et/ou dans lequel le matériau électriquement conducteur comporte ou est en cuivre et/ou cobalt et/ou tungstène.

4. Produit semi-conducteur selon la revendication 1 ou 3,
dans lequel le premier taux ou le au moins un deuxième taux du matériau électriquement conducteur est de 3 %, et/ou
dans lequel le au moins un deuxième taux du matériau électriquement conducteur est compris entre 1 % et 27 %, de manière préférée entre 1 % et 19 %, de manière plus préférée entre 11 % et 13 %, de manière la plus préférée est de 12 %.

5. Produit semi-conducteur selon l'une quelconque des revendications 1 à 4,
dans lequel la zone de transition (23, 33) comporte un troisième taux d'un matériau électriquement conducteur, en particulier comportant ou étant du cuivre et/ou du cobalt et/ou du tungstène, sur la zone correspondante de la zone de transition (23, 33).

6. Produit semi-conducteur selon la revendication 5,
dans lequel le troisième taux du matériau électriquement conducteur ne s'écarte pas de plus de 400 %, de manière préférée de pas plus de 270 %, de manière plus préférée de pas plus de 225 %, de manière la plus préférée de pas plus de 56,25 %, du au moins un deuxième taux du matériau électriquement conducteur sur la zone correspondante du au moins une seconde matrice de pastilles active (22a, 32a).

7. Produit semi-conducteur selon la revendication 5,
dans lequel le troisième taux du matériau électriquement conducteur ne s'écarte pas de plus de 400 %, de manière préférée de pas plus de 270 %, de manière plus préférée de pas plus de 225 %, de manière la plus préférée de pas plus de 56,25 %, du premier taux du matériau électriquement conducteur sur la zone correspondante de la première matrice de pastilles active (21a, 31a).

8. Produit semi-conducteur selon l'une quelconque des revendications 1 à 7,
dans lequel la première plaquette (21, 31) comporte une première zone supplémentaire (31c) présentant un premier taux supplémentaire d'un matériau électriquement conducteur sur la zone correspondante de la première zone supplémentaire (31c),
dans lequel la première zone supplémentaire (31c) est directement adjacente à la zone de transition (23, 33) et/ou non directement adjacente à la première matrice de pastilles active (21a, 31a), et/ou
dans lequel la au moins une seconde plaquette (22, 32) comporte au moins une seconde zone supplémentaire (32c) comportant au moins un deuxième taux supplémentaire d'un matériau électriquement conducteur sur la zone correspondante de la au moins une seconde zone supplémentaire (32c),
dans lequel la au moins une seconde zone supplémentaire (32c) est directement adjacente à la zone de transition (23, 33) et/ou non directement adjacente à la au moins une seconde matrice de pastilles active (22a, 32a), et/ou
dans lequel le matériau électriquement conducteur comporte ou est en cuivre et/ou cobalt et/ou tungstène.

9. Produit semi-conducteur selon la revendication 8,
dans lequel la première zone supplémentaire (31c) comporte une première matrice de pastilles inactive supplémentaire, et/ou
dans lequel la au moins une seconde zone supplémentaire (32c) comporte au moins une seconde matrice de pastilles inactive supplémentaire.

10. Produit semi-conducteur selon la revendication 8 ou 9, dans lequel le premier taux supplémentaire du matériau électriquement conducteur ne s'écarte pas de plus de 56,25 %, de manière préférée de pas plus de 25 %, de manière plus préférée de pas plus de 12,5 %, de manière la plus préférée de pas plus de 1 %, du au moins un deuxième taux du matériau électriquement conducteur sur la zone correspondante de la au moins une seconde matrice de pastilles active (22a, 32a), et/ou
dans lequel le au moins un second taux supplémentaire du matériau électriquement conducteur ne s'écarte pas de plus de 56,25 %, de manière préférée de pas de plus de 25 %, de manière la plus préférée de pas de plus de 12,5 %, de manière la plus préférée de pas de plus de 1 %, du premier taux du matériau électriquement conducteur sur la zone correspondante de la première matrice de pastilles active (21a, 31a).

11. Produit semi-conducteur selon l'une quelconque des revendications 8 à 10,
dans lequel le premier taux supplémentaire du matériau électriquement conducteur sur la zone correspondante de la première zone supplémentaire (31c) change en fonction d'un premier gradient, et/ou
dans lequel le au moins un second taux supplémentaire du matériau électriquement conducteur sur la zone correspondante de la au moins une seconde zone supplémentaire (32c) change en fonction d'un deuxième gradient.

12. Produit semi-conducteur selon l'une quelconque des revendications 5 à 7,
dans lequel le troisième taux du matériau électriquement conducteur sur la zone correspondante de la zone de transition change (23, 33) en fonction d'un troisième gradient.

13. Procédé de fabrication d'un produit semi-conducteur, le procédé comportant les étapes consistant à :
fournir une première plaquette (21, 31) comportant une première matrice de pastilles active (21a, 31a),
fournir au moins une seconde plaquette (22, 32) comportant au moins une seconde matrice de pastilles active (22a, 32a), et
assembler ensemble la première plaquette (21, 31) et la au moins une seconde plaquette (22, 32),
dans lequel la première plaquette (21, 31) et/ou la au moins une seconde plaquette (22, 32) comporte une zone de transition (23, 33) qui est directement adjacente à la première matrice de pastilles active (21a, 31a) et/ou la au moins une seconde matrice de pastilles actives (22a, 32a),
dans lequel la zone de transition (23, 33) comporte une matrice de pastilles inactive,
**caractérisé en ce que**
la première matrice de pastilles active (21a, 31a) présente un premier taux d'un matériau électriquement conducteur sur la zone correspondante de la première matrice de pastilles active (21a, 31a), et
le premier taux du matériau électriquement conducteur est compris entre 2 % et 4 %.
